(19) Europäisches Patentamt / European Patent Office / Office européen des brevets

(11) **EP 2 383 581 A1**

(12) **EUROPEAN PATENT APPLICATION**

(43) Date of publication:
02.11.2011 Bulletin 2011/44

(51) Int Cl.:
*G01R 19/10* [(2006.01)]  *G01R 19/165* [(2006.01)]
*H02H 3/38* [(2006.01)]

(21) Application number: 11163063.8

(22) Date of filing: 19.04.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 30.04.2010 KR 20100040941

(71) Applicant: LSIS Co., Ltd.
Dongan-gu, Anyang-si
Gyeonggi-do 431-080 (KR)

(72) Inventor: Lee, Chung Woo
Anyang-si, Gyeonggi-do 431-080 (KR)

(74) Representative: Löfgren, Håkan Bengt Alpo et al
Groth & Co KB
Box 6107
102 32 Stockholm (SE)

(54) **Apparatus for monitoring fault current in power system**

(57) Disclosed is an apparatus (20) for monitoring a fault current in a power system. The apparatus does not rectify an AC signal detected from a power system but full wave-rectifies the AC signal using a bridge diode (21-1,21-2) and then monitors a fault current. Particularly, current and voltage in the power system are respectively detected through a current transformer (13) and a Rogowski coil (15), and presence of occurrence of an accident is parallely monitored using the detected current and voltage. Thus, it is possible to prevent a response delay due to a rising time generated when the AC signal is smoothed to a DC signal through a capacitor and to prevent malfunction caused by chattering while performing a fast response at the time when a fault current is generated for the first time.

FIG. 1

EP 2 383 581 A1

Description

## BACKGROUND OF THE INVENTION

### 1. Field of the Invention

An aspect of the present invention relates to an apparatus for monitoring a fault current in a power system, and more specifically, to an apparatus for quickly monitoring a fault current when an accident caused by a stroke of lightning or a short circuit occurs in a power system.

### 2, Description of the Prior Art

When an accident caused by a stroke of lightning or a short circuit occurs in a power system, various apparatuses such as a superconducting fault current limiter or a digital protection relay are used to take action against the accident.

In order to protect devices in a power system, conditions of occurrence of an accident should be monitored as quickly as possible. To this end, presence of fault current may be detected by rectifying an AC (Alternating Current) signal inputted from the power system to a DC (Direct Current) signal. In this case, a charging time (rising time) of a capacitor is necessarily required, and therefore, it is difficult to quickly determine the presence of occurrence of the accident.

Particularly, such a problem may emerge as a more serious problem in an apparatus such as a superconducting fault current limiter, which requires a fast response speed.

## SUMMARY OF THE INVENTION

Embodiments of the present invention provide an apparatus for monitoring a fault current in a power system, which does not rectify an AC signal detected from a power system to a DC signal but immediately monitors a fault current generated in the AC signal, thereby quickly responding to the power system.

According to an aspect of the present invention, there is provided an apparatus for monitoring a fault current in a power system, the apparatus comprising: a first bridge diode configured to receive an AC current detected from a distribution line in the power system and full wave-rectify the received AC current; a second bridge diode configured to receive an AC voltage detected from the distribution line in the power system and full wave-rectify the received AC voltage; a first comparison unit configured to convert a current signal outputted from the first bridge diode into a voltage signal and output a high or low digital signal by comparing the converted voltage signal with a predetermined reference value; a second comparison unit configured to output a high or low digital signal by comparing a voltage signal outputted from the second bridge diode with a predetermined reference value; a first latch configured to latch an output value of the first comparison unit; a second latch unit configured to latch an output value of the second comparison unit; and a fault current output unit configured to output a fault signal informing that a fault current is generated based on the output values of the first and second latch units.

In some exemplary embodiments the first comparison unit may include a buffer configured to convert the current signal outputted from the first bridge diode into a voltage signal through a resistive element for voltage conversion and output the converted voltage signal; a comparator configured to receive the output signal of the buffer and the reference value respectively through inverting and non-inverting input terminals of an operational amplifier and output a high or low digital signal by comparing the output signal with the reference value; and an inverter configured to invert the output signal of the comparator and output the inverted signal.

In some exemplary embodiments the first latch unit may include a D latch having a digital signal input terminal to which a high signal is applied, a clock input terminal to which the output signal of the inverter is inputted, and an activation terminal connected to a switch unit that determines whether a latch operation is activated.

In some exemplary embodiments the second comparison unit may include a buffer configured to recede a voltage signal outputted from the second bridge diode and output the received voltage signal; a comparator configured to receive the output signal of the buffer and the reference value respectively through inverting and non-inverting input terminals of an operational amplifier and output a high or low digital signal by comparing the output signal with the reference value; and an inverter configured to invert the output signal of the comparator and output the inverted signal.

In some exemplary embodiments the second latch unit may include a D latch having a digital signal input terminal to which a high signal is applied, a clock input terminal to which the output signal of the inverter is inputted, and an activation terminal connected to a switch unit that determines whether a latch operation is activated.

In some exemplary embodiments the reference value may be configured to be variably determined by a user using a variable resistive element.

In some exemplary embodiments the apparatus may further include display units respectively connected to the first and second latch units so as to turn on/off light emitting diodes (LEDs) based on the output values thereof.

In some exemplary embodiments the apparatus may further include a display unit connected to the fault signal output unit so as to turn on/off an LED based on the output value thereof.

## BRIEF DESCRIPTION OF THE DRAWINGS

These and/or other aspects and advantages of the invention will become apparent and more readily appreciated from the following description of the embodiments, taken in conjunction with the accompanying drawings of which:

FIG. 1 is a diagram schematically showing a configuration of an apparatus for monitoring a fault current in a power system according to an embodiment of the present invention;

FIG. 2 is a circuit diagram showing internal circuit configurations of a first comparison unit and a second comparison unit; and

FIG. 3 is a circuit diagram showing an embodiment of a configuration of a first latch unit, a second latch unit and a fault signal output unit related to the first and second comparison units shown in FIG. 2.

## DETAILED DESCRIPTION OF PREFERRED EMBODIMENTS

Hereinafter, preferred embodiments will be described in detail with reference to the accompanying drawings.

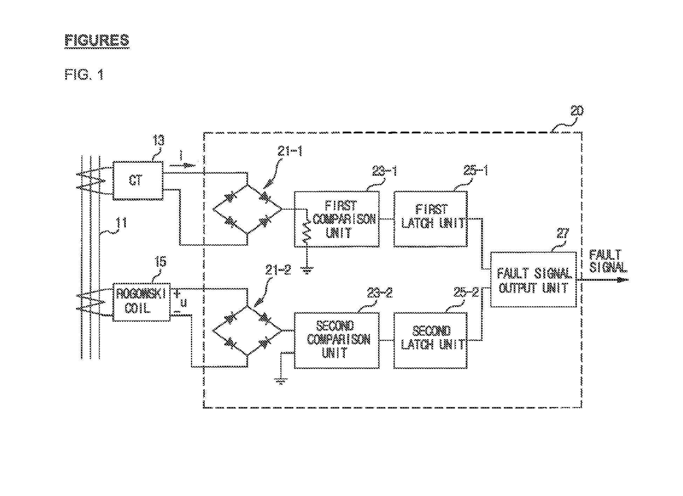

Referring to FIG. 1, an apparatus 20 for monitoring a fault current in a power system (hereinafter referred to as a fault current monitoring device) according to an embodiment of the present invention receives an AC current from a current transformer 13 for detecting current from a distribution line 11 in the power system, and receives a voltage detected from a Rogowski coil 15.

The fault current monitoring apparatus 20 includes a first bridge diode 21-1, a second bridge diode 21-2, a first comparison unit 23-1, a second comparison unit 23-2, a first latch unit 25-1, a second latch unit 25-2 and a fault signal output unit 27.

The first bridge diode 21-1 receives an AC current from the current transformer 13 and full wave-rectifies the received AC current. Then, the first bridge diode 21-1 outputs the full-wave rectified AC current. The second bridge diode 21-2 receives the AC voltage from the Rogowski coil 15 and full wave-rectifies the received AC voltage. Then, the second bridge diode 21-2 outputs the full-wave rectified AC voltage.

In this instance, the Rogowski coil 15 detects current in the distribution line 11. However, the Rogowski 15 is connected to a resistive element so as to transfer an AC voltage to the fault current monitoring apparatus 20.

The first and second bridge diodes 21-1 and 21-2 are used to full wave-rectify an AC current. However, the first and second bridge diodes 21-1 and 21-2 are not used to smooth the AC current to a DC current through a capacitor but used to monitor whether a fault signal is generated commonly with respect to both positive (+) and negative (-) regions of the AC signal.

The first comparison unit 23-1 converts a current signal outputted from the first bridge diode 21-1 into a voltage signal, and outputs a high or low digital signal by comparing the converted voltage signal with a predetermined reference value.

That is, the first comparison unit 23-1 functions to determine whether a fault current is generated based on the AC current outputted from the first bridge diode 21-1 If necessary, the first comparison unit 23-1 may be variously configured.

The second comparison unit 23-2 outputs a high or low digital signal by comparing the voltage signal outputted from the second bridge diode 21-2 with a predetermined reference value.

That is, the second comparison unit 23-2 functions to determine whether a fault current is generated based on the AC voltage outputted on the second bridge diode 21-2. If necessary, the second comparison unit 23-2 may be variously configured.

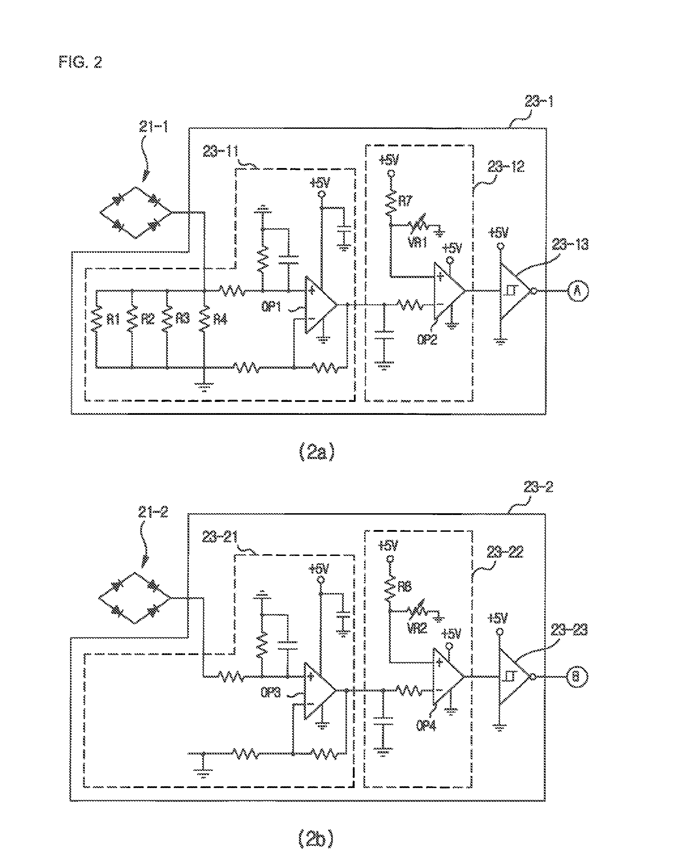

A specific embodiment of the first comparison unit 23-1 will be described with reference to FIG. 2A. The first comparison unit 23-1 may include a buffer 23-11, a comparator 23-12 and an inverter 23-13.

The buffer 23-11 includes resistive elements R1 to R4 for voltage conversion, which converts a current signal outputted from the first bridge diode 21-1 into a voltage signal, and outputs an input voltage through an operational amplifier OP1 as it is.

The comparator 23-12 may be configured using an operational amplifier OP2. An output signal from the buffer 23-11 is applied to an inverting input terminal of the operational amplifier OP2, and a reference value is inputted to a non-inverting input terminal of the operation amplifier OP2.

Therefore, if the voltage applied to the non-inverting input terminal is greater than that inputted to the Inverting input terminal, the operational amplifier OP2 outputs a high digital signal. If the voltage applied to the inverting input terminal is greater than that inputted to the non-inverting input terminal, the operational amplifier OP2 outputs a low digital signal.

The inverter 23-13 inverts an output signal from the comparator 23-12 and outputs the inverted signal.

If a fault current flows due to the occurrence of an accident in the distribution line 11, the voltage applied to the inverting input terminal of the operational amplifier OP2 will be greater than the reference value. Therefore, the comparator 23-12 outputs a low digital signal, and the digital signal is inverted by the inverter 23-13.

That is, if the fault current flows due to the occurrence of the accident in the distribution line 11, the first comparison unit 23-1 outputs a high digital signal.

A specific embodiment of the second comparator 23-2 will be described with reference to FIG. 2B. The second comparison unit 23-2 may include a buffer 23-21, a comparator 23-22 and an inverter 23-23.

The buffer 23-21 outputs an input voltage through an operational amplifier OP3 as it is.

The comparator 23-22 may be configured using an operational amplifier OP4. An output signal from the buffer 23-21 is applied to an inverting input terminal of the operational amplifier OP4, and a reference value is inputted to a non-inverting input terminal of the operation amplifier OP4.

Therefore, if the voltage applied to the non-inverting input terminal is greater than that inputted to the inverting input terminal, the operational amplifier OP4 outputs a high digital signal. If the voltage applied to the inverting input terminal is greater than that inputted to the non-inverting input terminal, the operational amplifier OP4 outputs a low digital signal.

The inverter 23-23 inverts an output signal from the comparator 23-22 and outputs the inverted signal.

If a fault current flows due to the occurrence of an accident in the distribution line 11, the voltage applied to the inverting input terminal of the operational amplifier OP4 will be greater than the reference value. Therefore, the comparator 23-22 outputs a low digital signal, and the digital signal is inverted by the inverter 23-23.

That is, if the fault current flows due to the occurrence of the accident in the distribution line 11, the second comparison unit 23-2 outputs a high digital signal.

In the embodiments, the reference values of the first and second comparison units 23-1 and 23-2 may be configured to be variably determined by a user using variable resistive elements VR1 and VR2, respectively.

In the embodiments shown in FIG. 2, the user can adjust the reference values by controlling the respective variable resistive elements VR1 and VR2.

The reference value applied to the non-inverting input terminal of the operational amplifier OP2 in the comparator 23-12 of the first comparison unit 23-1 is determined by the following expression 1.

Expression 1

$$\frac{\text{resistance of VR1}}{\text{resistance of R7} + \text{resistance of VR1}}$$

The reference value applied to the non-inverting input terminal of the operational amplifier OP4 in the comparator 23-22 of the second comparison unit 23-2 is determined by the following expression 2.

Expression 2

$$\frac{\text{resistance of VR2}}{\text{resistance of R8} + \text{resistance of VR2}}$$

Meanwhile, the first latch unit 25-1 latches an output value from the first comparison unit 23-1, and the second latch unit 25-2 latches an output value from the second comparison unit 23-2.

The first and second latch units 25-1 and 25-2 function to store a signal informing that a fault is generated until they are reset.

The fault signal output unit 27 outputs a fault signal informing that a fault current is generated according to the output values from the first and second latch units 25-1 and 25-2.

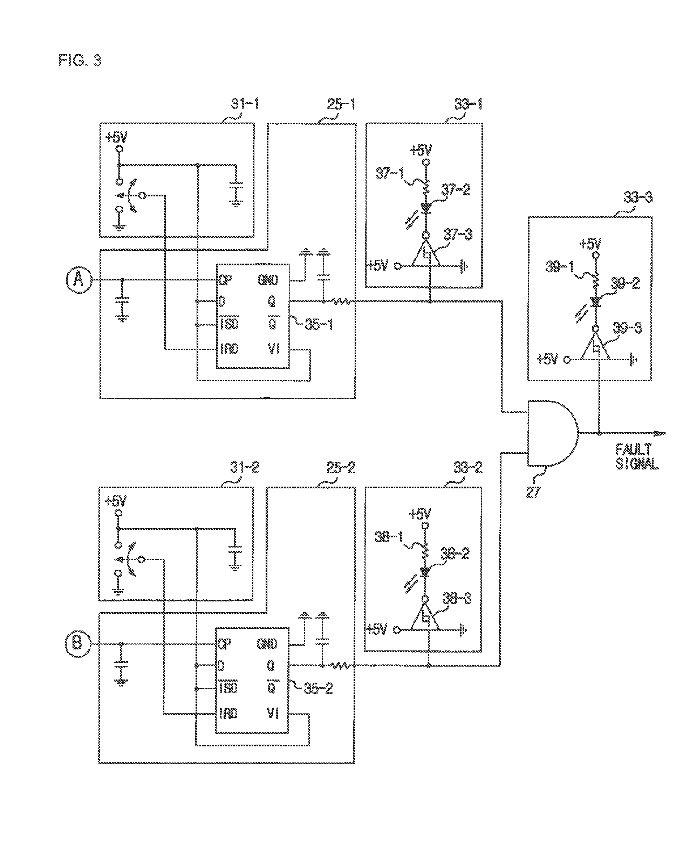

A specific embodiment of the first and second latch units 25-1 and 25-2 respectively connected to the first and second comparison units 23-1 and 23-2 shown in FIG. 2 will be described with reference to FIG. 3.

In the embodiments shown in FIG. 2, the first and second comparison units 23-1 and 23-2 respectively output high digital signals when a fault current is generated, and the first and second latch units 25-1 and 25-2 may be configured using D latches 35-1 and 35-2.

A high signal is applied to a digital signal input terminal D of the D latch 35-1 in the first latch unit 25-1, and an output signal from the inverter 23-13 is inputted to a clock input terminal CP. An activation terminal IRD is connected to a switch unit 31-1 for determining the presence of activation of a latch operation.

Therefore, if the output signal from the inverter 23-13 is changed from a low state to a high state, an output terminal Q of the D latch 35-1 at a rising edge becomes a high state.

The switch unit 31-1 allows the user to determine the presence of the activation of the latch operation. If a low signal is inputted to the activation terminal IRD of the D latch 35-1, the latch operation is not activated. If a high signal is inputted to the activation terminal IRD of the D latch 35-1, the latch operation is activated.

A high signal is applied to a digital signal input terminal D of the D latch 35-2 in the second latch unit 25-2, and an output signal from the inverter 23-23 is inputted to a clock input terminal CP. An activation terminal IRD is connected to a switch unit 31-2 for determining the presence of activation of a latch operation.

Therefore, if the output signal from the inverter 23-23 is changed from a low state to a high state, an output terminal Q of the D latch 35-2 at a rising edge becomes a high state.

The switch unit 31-2 allows the user to determine the presence of the activation of the latch operation. If a low signal is inputted to the activation terminal IRD of the D latch 35-2, the latch operation is not activated. If a high signal is inputted to the activation terminal IRD of the D latch 35-2, the latch operation is activated.

In the embodiment described above, the first and second latch units 25-1 and 25-2 respectively output high signals when a fault is generated, and hence the fault signal output unit 27 may be configured as an AND gate element.

That is, an AND gate element 27 outputs a fault signal when a fault is monitored from the AC current inputted from the current transformer 13 and the AC voltage inputted through the Rogowski coil 15.

Meanwhile, a display unit 33-1 for turning on/off a light emitting diode (LED) according to the output value of the first latch unit 25-1 may be connected to the first latch unit 25-1 so that the user can visually identify the presence of occurrence of an accident.

The embodiment shown in FIG. 3 will be described. The display unit 33-1 may be configured in a structure in which a resistive element 37-1 for current limiting, an LED 37-2 and an inverter 37-3 are connected in series to one another.

If a high signal is outputted from the first latch unit 25-1 in the occurrence of an accident, an output terminal of the inverter 37-3 becomes a low state. Then, current flows from a power source to the LED 37-2 through the resistive element 37-1 for current limiting, and accordingly, the LED 37-2 is turned on.

A display unit 33-2 for turning on/off an LED according to the output value of the second latch unit 25-2 may be connected to the second latch unit 25-2 so that the user can visually identify the presence of occurrence of an accident.

The embodiment shown in FIG. 3 will be described. The display unit 33-2 may be configured in a structure in which a resistive element 38-1 for current limiting, an LED 38-2 and an inverter 38-3 are connected in series to one another.

If a high signal is outputted from the second latch unit 25-2 in the occurrence of an accident, an output terminal of the inverter 38-3 becomes a low state. Then, current flows from a power source to the LED 38-2 through the resistive element 38-1 for current limiting, and accordingly, the LED 38-2 is turned on.

A display unit 33-3 for turning on/off an LED according to the output value of the fault signal output unit 27 may be connected to the fault signal output unit 27 so that the user can visually identify the presence of occurrence of an accident.

The embodiment shown in FIG. 3 will be described. The display unit 33-3 may be configured in a structure in which a resistive element 39-1 for current limiting, an LED 39-2 and an inverter 39-3 are connected in series to one another,

If a high signal is outputted from the fault signal output unit 27 in the occurrence of an accident, an output terminal of the inverter 39-3 becomes a low state. Then, current flows from a power source to the LED 39-2 through the resistive element 39-1 for current limiting, and accordingly, the LED 39-2 is turned on.

As described above, according to embodiments of the present invention, an AC signal detected from a power system is passed through a bridge diode, and in this state, the presence of occurrence of an accident is immediately determined. Thus, it is possible to prevent a response delay due to a rising time generated when the AC signal is smoothed to a DC signal through a capacitor and to quickly respond to the power system.

The presence of occurrence of a fault in the power system is parallely monitored using a current transformer and a Rogowski coil. If a fault waveform is generated once, it is latched so that a corresponding state is maintained until a reset is performed. Then, a fault signal is outputted when the fault is monitored from the current transformer and the Rogowski coil.

Accordingly, it is possible to prevent malfunction caused by chattering. Further, since a response can be quickly performed at the time when a fault current is generated for the first time, it is possible to be effectively applied to power system protection apparatuses such as a superconducting limiter, which require fast response characteristics.

Although a few embodiments of the present invention have been shown and described, it would be appreciated by those skilled in the art that changes may be made in this embodiment without departing from the principles and spirit of the invention, the scope of which is defined in the claims and their equivalents.

**Claims**

1.  An apparatus (20) for monitoring a fault current in a power system, the apparatus (20) **characterized by**:

    a first bridge diode (21-1) configured to receive an AC current detected from a distribution line (11) in the power system and full wave-rectify the received AC current;
    a second bridge diode (21-2) configured to receive an AC voltage detected from the distribution line (11) in the power system and full wave-rectify the received AC voltage;
    a first comparison unit (23-1) configured to convert a current signal outputted from the first bridge diode (21-1) into a voltage signal and output a high or low digital signal by comparing the converted voltage signal with a predetermined reference value;
    a second comparison unit (23-2) configured to output a high or low digital signal by comparing a voltage signal outputted from the second bridge diode (21-2) with a predetermined reference value;
    a first latch unit (25-1) configured to latch an output value of the first comparison unit;
    a second latch unit (25-2) configured to latch an output value of the second comparison unit; and
    a fault current output unit (27) configured to output a fault signal informing that a fault current is generated based on the output values of the first and second latch units (25-1, 25-2).

2.  The apparatus of claim 1, **characterized in that** the first comparison unit (23-1) comprises:

    a buffer (23-11) configured to convert the current signal outputted from the first bridge diode (21-1) into a voltage signal through a resistive element (R1-R4) for voltage conversion and output the converted voltage signal;
    a comparator (23-12) configured to receive the output signal of the buffer (23-11) and the reference value respectively through inverting and non-inverting input terminals of an operational amplifier (OP2) and output a high or low digital signal by comparing the output signal with the reference value; and
    an inverter (23-13) configured to invert the output signal of the comparator (23-12) and output the inverted signal.

3.  The apparatus of claim 2, **characterized in that** the first latch unit (25-1) comprises a D latch (35-1) having a digital signal input terminal to which a high signal is applied, a clock input terminal to which the output signal of the inverter (23-13) is inputted, and an activation terminal connected to a switch unit (31-1) that determines whether a latch operation is activated.

4.  The apparatus of claim 1, **characterized in that** the second comparison unit (23-2) comprises:

    a buffer (23-21) configured to receive a voltage signal outputted from the second bridge diode (21-2) and output the received voltage signal;
    a comparator (23-22) configured to receive the output signal of the buffer (23-21) and the reference value respectively through inverting and non-inverting input terminals of an operational amplifier (OP4) and output a high or low digital signal by comparing the output signal with the reference value; and
    an inverter (23-23) configured to invert the output signal of the comparator (23-22) and output the inverted signal.

5.  The apparatus of claim 4, **characterized in that** the second latch unit (25-2) comprises a D latch (35-2) having a digital signal input terminal to which a high signal is applied, a clock input terminal to which the output signal of the inverter (23-23) is inputted, and an activation terminal connected to a switch unit (31-2) that determines whether or not a latch operation is activated.

6.  The apparatus of claim 1, **characterized in that** the reference value is configured to be variably determined by a user using a variable resistive element (VR1 or VR2).

7.  The apparatus of claim 1, **characterized by** further comprising display units (33-1, 33-2) respectively connected to the first and second latch units (35-1, 35-2) so as to turn on/off light emitting diodes (LEDs) based on the output values thereof.

8.  The apparatus of claim 1, **characterized by** further comprising a display unit (33-3) connected to the fault signal output unit (27) so as to turn on/off an LED based on the output value thereof.

**FIGURES**

FIG. 1

FIG. 2

(2a)

(2b)

FIG. 3

EP 2 383 581 A1

**EUROPEAN SEARCH REPORT**

Europäisches Patentamt
European Patent Office
Office européen des brevets

Application Number

EP 11 16 3063

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 671 807 A (MILLIGAN LEE J) 20 June 1972 (1972-06-20) * abstract; figures 1,2 * * column 2, line 24 - column 5, line 2 * | 1-8 | INV. G01R19/10 G01R19/165 H02H3/38 |
| A | EP 0 286 282 A2 (FUJI ELECTROCHEMICAL CO LTD [JP]) 12 October 1988 (1988-10-12) * abstract; figures 1-3 * * column 2, line 5 - line 41 * | 1-8 | |
| A | US 3 836 854 A (WEHMAN A) 17 September 1974 (1974-09-17) * abstract; figure 1 * | 1-8 | |
| X | JP 3 279875 A (MATSUSHITA ELECTRIC WORKS LTD) 11 December 1991 (1991-12-11) * abstract; figures 1,6 * | 1,7,8 | |
| A | US 4 362 986 A (BURKE JAMES J ET AL) 7 December 1982 (1982-12-07) * abstract; figures 5-7 * * column 4, line 7 - column 5, line 24 * | 1-8 | TECHNICAL FIELDS SEARCHED (IPC) |
| A | US 4 263 635 A (WELK STEVEN) 21 April 1981 (1981-04-21) * abstract; figure 2 * | 1-8 | G01R H02H |
| A | US 4 728 898 A (STALEY JR ROYCE E [US]) 1 March 1988 (1988-03-01) * abstract; figure 1 * | 1-8 | |

The present search report has been drawn up for all claims

| Place of search | Date of completion of the search | Examiner |
|---|---|---|
| Berlin | 7 September 2011 | Ernst, Monika |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**            EP 11 16 3063

This annex lists the patent family members relating to the patent documents cited in  the above-mentioned European search report.
The members are as contained in the European Patent Office EDP file on
The European Patent Office is in no way liable for these particulars which are merely given for the purpose of information.

07-09-2011

| Patent document cited in search report | | Publication date | Patent family member(s) | | Publication date |
|---|---|---|---|---|---|
| US 3671807 | A | 20-06-1972 | NONE | | |
| EP 0286282 | A2 | 12-10-1988 | DE | 3853847 D1 | 29-06-1995 |
| | | | DE | 3853847 T2 | 02-11-1995 |
| | | | JP | 63238566 A | 04-10-1988 |
| | | | US | 4864163 A | 05-09-1989 |
| US 3836854 | A | 17-09-1974 | CA | 1002604 A1 | 28-12-1976 |
| JP 3279875 | A | 11-12-1991 | NONE | | |
| US 4362986 | A | 07-12-1982 | NONE | | |
| US 4263635 | A | 21-04-1981 | NONE | | |
| US 4728898 | A | 01-03-1988 | NONE | | |

EPO FORM P0459

For more details about this annex : see Official Journal of the European Patent Office, No. 12/82